# EUROPEAN PATENT SPECIFICATION

(11) **EP 0 376 645 B1**
(45) Date of publication and mention of the grant of the patent: **01.03.1995**
(21) Application number: 89313510.3
(22) Date of filing: 22.12.1989
(51) Int. Cl.: G11C 5/00

(54) **Ceramic package for memory semiconductor**
Keramisches Modul für Halbleiterspeicher
Module céramique pour mémoire à semi-conducteurs

(30) Priority: 26.12.1988 JP 167871/88
(43) Date of publication of application: 04.07.1990
(73) Proprietor: NGK INSULATORS, LTD., Nagoya City Aichi Pref. (JP)
(72) Inventor: Ohashi, Toshio, Komaki City Aichi Pref. (JP); Wakayama, Masaki, Kasugai City Aichi Pref. (JP)
(74) Representative: Paget, Hugh Charles Edward

(56) References cited:
- US-A- 4 629 824
- PATENT ABSTRACTS OF JAPAN, vol. 11, no. 314 (E-549)[2761], 13th October 1987;& JP-A-62 106 653 (MITSUBISHI ELECTRIC CORP.) 18-05-1987
- PATENT ABSTRACTS OF JAPAN, vol. 9, no. 140 (E-321)[1863], 14th June 1985;& JP-A-60 21 544 (HITACHI OUME DENSHI K.K.) 02-02-1985
- PATENT ABSTRACTS OF JAPAN, vol. 11, no. 23 (E-473)[2470], 22nd January 1987;
- PATENT ABSTRACTS OF JAPAN, vol. 11, no. 306 (E-546)[2753], 6th October 1987;& JP-A-62 98 649 (HITACHI LTD) 08-05-1987
- PATENT ABSTRACTS OF JAPAN, vol. 11, no. 161 (E-509)[2608], 23rd May 1987;& JP-A-61 294 842 (NEC CORP.) 25-12-1986
- PATENT ABSTRACTS OF JAPAN, vol. 11, no. 217 (E-523)[2664], 14th July 1987;& JP-A-62 37 949 (MATSUSHITA ELECTRONICS CORP.) 18-02-1987
- IBM TECHNICAL DISCLOSURE BULLETIN, vol. 29, no. 7, December 1986, pages 3085-3087, New York, US; "Technique for obtaining an environmentally secure adhesiveseal"

## Description

This invention relates to a ceramic package for a memory semiconductor, and more particularly to a package for EPROM (erasable and programmable read only memory) which is able to erase informations once memorized by irradiation of ultraviolet rays.

A package for EPROM has been disclosed in Japanese Patent Application Laid-open No. 61-194,751, in which an EPROM semiconductor element is arranged in a recess of a ceramic package and the recess is hermetically closed through a glassy material by an ultraviolet ray transmissible ceramic or glass lid.

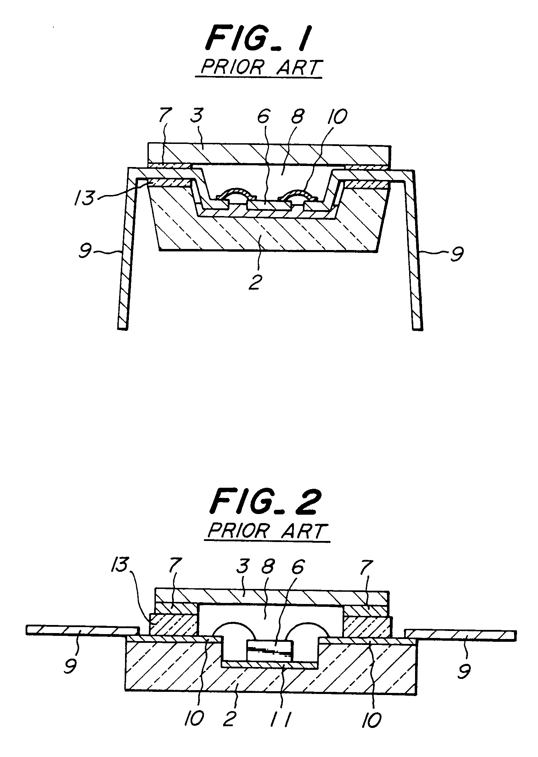

In more detail, as shown in Fig. 1, a semi-conductor element 6 and lead members 9 are fixed through glass layers 7 to a ceramic package 2 formed in its upper surface with a recess 8. Plate-shaped ceramic or glass lid 3 is fixed through the glass layer 7 to the upper surface of the ceramic package 2 to seal the recess from atmosphere.

Moreover, a ceramic package as shown in Fig. 2 has also been known. In this case, a bottom 11 of a recess 8 of the ceramic package 2, wire bonding portions 12 and a conductor 10 are metallized, respectively. Lead members 9 are brazed to both ends of the conductor 10. A ceramic frame 13 is arranged on an upper surface of the conductor 10 for locating a lid 3 thereon. The ceramic lid 3 is fixed to an upper surface of the ceramic frame 13 by glass-sealing or brazing.

Alumina ceramic materials are generally used for the ceramic packages in consideration of thermal expansion, thermal conductivity, electrical characteristics as insulation resistance and the like, and mechanical strength. In order to be coincident with the package in thermal expansion, therefore, optically transmissible polycrystalline alumina is generally used as a material for the lid as disclosed in Japanese Patent Application Publication Nos. 39-240 and 47-51,801 Japanese Patent Application Laid-open No. 63-242,964.

IBM Technical Disclosure Bulletin Vol. 29 No.7 (December 1986) pages 3085-7 discloses a package in which a groove extends around the sealing region of a lid to house a metallic preform. JP-A-6021544 (Hitachi) discloses the use of recesses in the sealing surfaces of the package and the lid to increase the surface area of the surfaces, which are then sealed by cast metal.

On the other hand, in order to accomplish higher degree of information processing and miniaturization, it has been required to increase memory amounts of the EPROM semiconductor elements and at the same time to miniaturize the ceramic packages for the memory semiconductor elements has a limitation, sizes of the elements progressively increase as increasing the memory amounts. Moreover, sizes of the ceramic packages for the memory semiconductors have been standardized for the purpose of applying to circuit substrates as printed circuit boards. Therefore, it is difficult to change the sizes of the ceramic packages according to the increase of the sizes of the semiconductor elements.

This fact will be explained in a following example. It is assumed that a ceramic package (except a lid) has a width of 11 mm, a length of 20 mm and a thickness of 1.7 mm, an ultraviolet ray irradiated portion of a semiconductor element need to have a size of about 9 mm × 9 mm for 1 M bit and about 9 mm × 14 mm for 2 M bit. In this case, a sealing portion of the ultraviolet ray transmissible lid to the ceramic package need to have a width of about 1 mm for 1 and 2 M bit and a length of 11 mm for 1 M bit and 6 mm for 2 M bit. In other words, sealed areas are 139 mm² for 1 M bit and 94 mm² for 2 M bit. Accordingly, if an EPROM semi-conductor element for 2 M bit is applied to a ceramic package hitherto standardized, sealing strength between the ceramic lid and the package becomes weak so that an air-tightness in the package is insufficient.

It is an object of the invention to provide a ceramic package capable of accommodating a high density memory semiconductor element which eliminates or reduces disadvantages of the prior art.

The invention provides a ceramic package accommodating therein a memory semi-conductor, as set out in claim 1.

According to the invention, the ceramic lid is formed with the groove in the sealing portion with the ceramic package so that the groove increases the sealing area which serves to improve the sealing strength, shearing strength, and air-tightness. Moreover, the ceramic package of the invention can provide the advantage that even if memory amounts of the semiconductor element increase, enlargement of the ceramic package can be avoided.

The invention will be more fully understood by referring to the following detailed specification and claims taken in connection with the appended drawings.
Figs. 1 and 2 are sectional views illustrating ceramic packages for memory semi-conductors of the prior art;
Fig. 3 is a sectional view illustrating one embodiment of a ceramic package for a memory semiconductor according to the invention;
Fig. 4 is a plan view of a ceramic lid used in the ceramic package shown in Fig. 3;
Fig. 5 is a sectional view of the lid taken along the line V -V in Fig. 4;
Fig. 6 is a plan view of another embodiment of a ceramic lid used in the invention; and
Fig. 7 is a sectional view illustrating a further embodiment of a ceramic package for a memory semiconductor according to the invention.

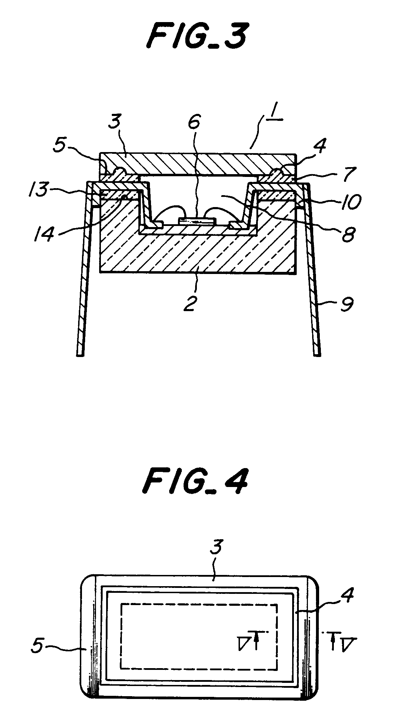

Fig. 3 illustrates one embodiment of a ceramic package for a memory semiconductor according to the invention. The ceramic package 2 made of alumina or the like is formed in its upper surface with a recess 8. An EPROM semiconductor element 6 for memory is arranged on a bottom of the recess 8. Lead members 9 are secured to the package 2 from the bottom along side walls and shoulders 14 of the package 2 by means of glass layers 7. A ceramic lid 3 in the form of a flat plate is fixed to an upper surface of the ceramic package 2 through a glass layer 7 between the shoulders 14 and a sealing portion 5 of the ceramic lid 3 to seal the recess 8 from atmosphere.

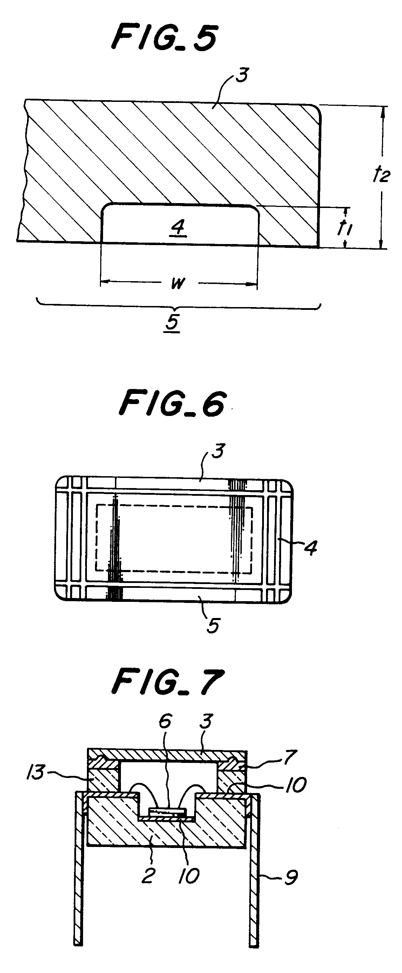

As shown in Figs. 4 and 5, the lid 3 is formed at the sealing portion 5 with a groove 4 located substantially at a center of the sealing portion 5 along its all circumference.

A sectional shape of the groove 4 is rectangular having a width w and a depth t₁ as shown in Fig. 5. The width w is dependent on a width of the shoulder 14 of the package 2 or a size of the sealing portion 5 and usually 0.35-0.5 mm.

The depth t₁ is to be as large as possible in consideration of a thickness t₂ and a mechanical strength of the ceramic lid 3 so as to make higher the bonding strength between the lid 3 and the ceramic package 2 and at the same time to improve an air-tightness of the recess 8. On the other hand, however, the thickness t₂ of the ceramic lid 3 is preferably as thin as possible in order to miniaturize the ceramic package and to increase the transmission of ultraviolet rays. In the case using an ultraviolet ray transmissible polycrystalline alumina, therefore, the thickness t₂ is 0.2-0.35 mm in view of its mechanical strength, whereas the depth t₁ is preferably 40-80 »m which is less than one half of the value of t₂. The thickness t₁ is more preferably about 50 »m in consideration of a producing method later described.

A material of the lid is preferably an optically transmissible polycrystalline alumina having an optical transmission of more than 60% with a wave length of 2,537 Å at a thickness of 0.2 mm of the lid. For example, materials of Aℓ₂O₃-MgO group and Aℓ₂O₃-MgO rare earth group disclosed in Japanese Patent Application Publications Nos. 39-240 and 47-51,801 are used. However, a polycrystalline alumina having crystal grain diameters less than 8 »m and superior in bending strength as disclosed in Japanese Patent Laid-open No. 63-242,964 is more preferable.

The configuration of the groove 4 is not limited to that shown in Fig. 4. For example, plural grooves may be partially arranged as shown in Fig. 6. In the embodiment shown in Fig. 6, a plurality of intersecting straight grooves are arranged along sides of the lid 3. Moreover, different from the groove 4 extending all over the sealing portion 5 as shown in Figs. 4 and 5, grooves may be partially provided so long as a sealing strength between the ceramic lid and the package is securely more than a predetermined value.

Furthermore, the construction of the ceramic package is not limited to that shown in Fig. 3. For example, the invention is applicable to a ceramic package as shown in Fig. 7. In this case, a bottom of a recess of a ceramic package and a conductor 10 are metallized and lead members 9 is brazed to both ends of the conductor 10. A ceramic frame 13 is arranged on an upper surface of the conductor 10 and a ceramic lid 3 is fixed to an upper surface of the ceramic frame by glass-sealing.

In forming the groove 4 of the ceramic lid, diamond blades may be used to form the groove at predetermined positions in a green body or sintered body of polycrystalline alumina. It is preferable for mass-production to press green bodies by means of metal dies having protrusions corresponding to the groove. Thereafter, the green bodies are fired to make ceramic lids.

### Example

Aluminum oxide powder having a purity of more than 99.9% and a specific surface area of 5.2 mm²/g obtained by thermal decomposition of aluminum ammonium sulfate was mixed with magnesium oxide of 0.1 weight % and binding aids (polyvinyl alcohol and polyethylene glycol) to prepare a powder for pressing. The powder was pressed into a green body at a pressure of 2,000 kg/cm² by the use of a metal die having protrusions corresponding to the groove shown in Fig. 4 or 5 and a metal die devoid of a protrusion. The green body was then fired at 1,500°C in a non-oxidizing atmosphere to obtain a ceramic lid having a width of 1 mm, a length of 20 mm and a thickness of 0.25 mm. A width and a depth of the ceramic lid were 0.4 mm and 0.05 mm. The lid was then adhered through glass layers and lead members to a package made of black alumina as shown in Fig. 3 to obtain a ceramic package for a memory semiconductor.

Adhered strengths of the lids to the ceramic packages thus produced were tested by measuring shearing strengths when loads were applied to sides of the lids. Packages having grooves in lids exhibited adhered strengths 1.5 times higher than those of packages having no grooves. On the other hand, ceramic packages were put in the thermal cycle condition whose temperatures were kept at 0° and 100°C respectively for six minutes. Such a thermal cycle was repeated fifteen times and thereafter air-tightness were inspected by means of a helium leak detector. No packages having grooves exhibited air-tightness less than 10⁻¹⁰ atm·cc/sec. Three packages among ten packages having no grooves exhibited air-tightness less than 10⁻¹⁰ atm·cc/sec.

As can be seen from the above explanation, the ceramic package for a memory semiconductor according to the invention is superior in sealing strength, air-tightness and ultraviolet ray transmission and can easily accommodate any increase of memory amount of semiconductor elements. The ceramic package according to the invention has such significant effects and is very effective in practical use.

## Claims

1. A ceramic package (2) accommodating therein a memory semiconductor (6) and sealingly closed by a polycrystalline alumina ceramic lid (3) which is transparent to ultraviolet rays and has a peripheral sealing region (5) sealed to an opposing sealing region (14) of the package (2) by a glass layer (7) characterized in that at least one groove (4) extends around the peripheral sealing region (5), the glass layer (7) filling said at least one groove (4).

2. A ceramic package (2) as set forth in claim 1, wherein said sealing region (14) of said package is flat.

3. A ceramic package as set forth in claim 1 or claim 2 wherein at least one said groove (4) is located substantially at a center of the sealing region around the whole circumference of the lid.

4. A ceramic package as set forth in claim 1 or claim 2, wherein there is a plurality of said grooves (4) which are intersecting straight grooves along sides of the lid.

5. A ceramic package as set forth in any one of claims 1 to 4, wherein the or each said groove (4) has a rectangular cross-section.

6. A ceramic package as set forth in any one of claims 1 to 5, wherein the depth of the or each groove (4) is less than one half of a thickness of the lid (3).

7. A ceramic package as set forth in claim 6, wherein the thickness of the lid (3) is in the range 0.2-0.35 mm and the depth of the or each groove (4) is in the range 40-80 »m, preferably 50 »m.

8. A ceramic package as set forth in any one of claims 1 to 7 wherein said lid (3) is made of polycrystalline alumina of the Al₂O₃-MgO type or Al₂O₃-MgO rare earth metal type.

## Patentansprüche

1. Keramische (s) Modul bzw. Einheit (2), das bzw. die darin einen Halbleiterspeicher (6) aufnimmt und durch einen polykristallinen Tonerde-Keramikdeckel (3) dicht abgeschlossen ist, der gegenüber ultravioletten Strahlen durchlässig ist und einen peripheren Abdichtbereich (5) aufweist, der durch eine Glasschicht (7) gegenüber einem gegenüberliegenden Abdichtbereich (14) abgedichtet ist, dadurch gekennzeichnet, daß sich zumindest eine Nut (4) um den peripheren Abdichtbereich (5) erstreckt, wobei die Glasschicht die genannte zumindest eine Nut (4) füllt.

2. Keramische(s) Modul bzw. Einheit (2) nach Anspruch 1, worin der genannte Abdichtbereich (14) des genannten Moduls flach ist.

3. Keramische(s) Modul bzw. Einheit nach Anspruch 1 oder Anspruch 2, worin zumindest eine genannte Nut (4) im wesentlichen in einem Zentrum des Abdichtbereichs um den gesamten Deckelumfang angeordnet ist.

4. Keramische(s) Modul bzw. Einheit nach Anspruch 1 oder Anspruch 2, worin eine Vielzahl an genannten Nuten (4) vorhanden ist, die gerade Nuten entlang der Seiten des Deckels schneiden.

5. Keramische(s) Modul bzw. Einheit nach einem der Ansprüche 1 bis 4, worin die oder jede genannte Nut (4) einen rechteckigen Querschnitt aufweist.

6. Keramische(s) Modul bzw. Einheit nach einem der Ansprüche 1 bis 5, worin die Tiefe der oder jeder Nut (4) geringer als die Hälfte einer Dicke des Deckels (3) ist.

7. Keramische(s) Modul bzw. Einheit nach Anspruch 6, worin die Dicke des Deckels (3) im Bereich von 0,2-0,35 mm und die Tiefe der oder jeder Nut (4) im Bereich von 40-80 »m, vorzugsweise 50 »m, liegt.

8. Keramische(s) Modul bzw. Einheit nach einem der Ansprüche 1 bis 7, worin der genannte Deckel (3) aus polykristalliner Tonerde des Al₂O₃-MgO-Typs oder des Al₂O₃-MgO-Seltenerdmetalltyps besteht.

## Revendications

1. Boîtier en céramique (2) recevant dans celui-ci une mémoire à semi-conducteurs (6) et fermé de façon étanche par un couvercle en céramique d'alumine polycristalline (3) qui est transparent aux rayons ultra-violets et comporte une région d'étanchement périphérique (5) scellée à une région d'étanchement opposée (14) du boîtier (2) par une couche de verre (7) caractérisé en ce qu'au moins une rainure (4) s'étend autour de la région d'étanchement périphérique (5), la couche de verre (7) remplissant ladite au moins une rainure (4).

2. Boîtier en céramique (2) selon la revendication 1, dans lequel la région d'étanchement précitée (14) du boîtier est plane.

3. Boîtier en céramique selon la revendication 1 ou la revendication 2 dans lequel au moins la rainure précitée (4) est située sensiblement à un centre de la région d'étanchement autour de toute la circonférence du couvercle.

4. Boîtier en céramique selon la revendication 1 ou la revendication 2, dans lequel se trouve un certain nombre de rainures précitées (4) qui sont des rainures rectilignes s'intersectant le long de côtés du couvercle.

5. Boîtier en céramique selon l'une quelconque des revendications 1 à 4, dans lequel chaque rainure (4) a une section rectangulaire.

6. Boîtier en céramique selon l'une quelconque des revendications 1 à 5, dans lequel la profondeur de la ou de chaque rainure (4) est inférieure à une moitié d'une épaisseur du couvercle (3).

7. Boîtier en céramique selon la revendication 6, dans lequel l'épaisseur du couvercle (3) est dans la gamme de 0,2-0,35mm et la profondeur de la ou de chaque rainure (4) dans la gamme de 40-80»m, de préférence 50»m.

8. Boîtier en céramique selon l'une quelconque des revendications 1 à 7 dans lequel le couvercle précité (3) est réalisé en alumine polycristalline du type Al₂O₃-MgO ou du type à métal de terre rare Al₂O₃-MgO.
